# EUROPEAN PATENT APPLICATION

(11) **EP 3 203 147 A1**
(43) Date of publication of application: **09.08.2017**
(21) Application number: 16194997.9
(22) Date of filing: 21.10.2016
(51) Int. Cl.: F21V 29/51

(54) **HIGH POWER LED ILLUMINANT BASED ON HEAT PIPE PRINCIPLE**

(30) Priority: 03.02.2016 CN 201610085453
(71) Applicant: Zhang, Guosheng, Beijing 102600 (CN)
(72) Inventor: Zhang, Guosheng, Beijing 102600 (CN)
(74) Representative: Patentwerk B.V.

(57) **Abstract**

The present invention relates to the field of LED illumination, particularly to a high power LED illuminant based on heat pipe principle. The high power LED illuminant comprises a light emitting section, a liquid storing section with liquid electric-insulation-operating-medium stored therein and a heat sink. The liquid electric-insulation-operating-medium is drawn into the light emitting section by means of capillary force and then immerses the LED chips and thus directly cools down the LED chips. The electric-insulation-operating-medium takes in heat and turns into gas and then flows into the liquid storing section through capillary channels. The heat sink is used to cool down the electric-insulation-operating-medium so that it turns into liquid. When the LED chips generate heat during its operation, the electric-insulation-operating-medium flows into the heat sink after turning into gas by absorbing heat. The electric-insulation-operating-medium turns into liquid after giving out heat through the heat sink. By means of such a cycle, the heat generated by LED chips is so transferred away via the electric-insulation-operating-medium that the temperature of the LED chips is kept within the temperature range of gaseous electric-insulation-operating-medium. In this way, the lifespan of the LED chips is extended consequently and the luminous efficiency is enhanced as well.

## Description

### TECHNICAL FIELD

The present invention relates to the field of LED illumination, particularly to a high power LED illuminant based on heat pipe principle.

### BACKGROUND

With the rapid development of LED industry, the research on it is deepened. Heat dissipation of the LED attracts more and more attention, because the luminous decay or lifespan of LED is directly related to its junction temperature. Poor heat dissipation leads to higher junction temperature, lower luminous efficiency and shorter lifespan. According to Arrhenius principle, the lifespan of LED will increase by 2 times as temperature drops by 10 degree. Nowadays, nearly all LED lights employ aluminum based circuit board. Cooling device is located on the back of metal based plate to indirectly cool down the LED chips. The thickness and width of copper foil of circuit on aluminum based plate must be sufficient to conduct electric and heat, wherein the thickness ranges from 35µm to 280µm and the width preferably spreads substantially throughout the whole aluminum based plate in order to transfer the heat down. The underneath insulator must possess both good insulativity and sound thermal conductivity. However, the insulativity and thermal conductivity contradict one another. Generally speaking, conductor does well in thermal conductivity and insulator has poor thermal conductivity. It is difficult to possess both good insulativity and excellent thermal conductivity.

### SUMMARY OF THE INVENTION

The present invention provides a high power LED illuminant based on heat pipe principle to solve the above described technical problems, wherein the LED chips are directly cooled down.

To achieve the above described objective, the technical solutions of the present invention are detailed as follows:
A high power LED illuminant based on heat pipe principle comprises a light emitting section, a liquid storing section with liquid electric-insulation-operating-medium stored therein and a heat sink, wherein the LED chips are directly cooled down;
wherein a first chamber is provided within the light emitting section and the LED chips are located within the first chamber; the first chamber has clearance ranging from 0.01mm to 2mm;
wherein the liquid electric-insulation-operating-medium is drawn into the light emitting section by means of capillary force and the electric-insulation-operating-medium takes in heat and then turns into gas;
wherein the liquid storing section is provided with a second chamber in which the liquid electric-insulation-operating-medium is stored;
the heat sink is used for lowering temperature of the gas electric-insulation-operating-medium to change it into liquid.

Preferably, the first chamber is formed by holding two pieces of transparent material together and sealing their edges.

Preferably, the first chamber is formed by holding metal based circuit board(s) and transparent material(s) together and sealing their edges.

Preferably, the transparent material is transparent glass, transparent ceramics, transparent fluorescent ceramics, fluorescent glass, fluorescent film glass, lattice fluorescent film glass, fluorescent polymer film doped with fluorescent powder or other transparent materials.

Preferably, a circuit and the LED chips are located within the first chamber and the LED chips are fixed on and electrically connected to the circuit.

Preferably, a connecting section with capillary structure is provided between the light emitting section and the liquid storing section and connects them with each other.

Preferably, the liquid storing section and the heat sink is an integral metal sealing structure.

Compared with the prior art, the advantages of the present application include: the LED chips in the high power LED illuminant are directly cooled down by means of capillary principle of heat pipe; the dimension of the inner clearance of the first chamber of the light emitting section ranges from 0.01mm to 2mm, forming capillary structure and capillary channel is created in the first chamber and the connecting section with principle of heat pipe. The liquid electric-insulation-operating-medium is drawn into the first chamber by means of capillary force to immerse the LED chips in order to directly cool down the LED chips. When the LED chips generate heat during its operation, the electric-insulation-operating-medium takes in heat, turns into gas and then flows into the liquid storing section through capillary channel of the connecting section. Heat will be taken in during the process of transition into gas. After taking in heat, the electric-insulation-operating-medium flows through the connecting section into the liquid storing section. After giving out heat through the heat sink, the electric-insulation-operating-medium turns into liquid. By means of the above described cycle, the heat generated by LED chips is transferred away from the chips via vaporization and liquefaction of the electric-insulation-operating-medium, thus keeping the temperature of the LED chips within the vaporization temperature of the electric-insulation-operating-medium. The lifespan of the LED chips is extended consequently and the luminous efficiency is enhanced as well.

### BRIEF DESCRIPTION OF THE DRAWINGS

In order to illustrate the specific embodiments of the invention and the technical solutions in the prior art more clearly, drawings related to the description of those embodiments and the prior art will be described briefly. Apparently, some embodiments of the invention are described with reference to the following figures. However, other embodiments and related figures can be envisaged by those skilled in the art without inventive work.
Figure 1 is a structural representation of a high power LED illuminant based on of heat pipe principle in a specific embodiment of the invention;
Figure 2 is a structural side view of a high power LED illuminant based on heat pipe principle in a specific embodiment of the invention;
Figure 3 is a structural representation of a high power LED illuminant based on heat pipe principle in a specific embodiment of the invention, which is provided with a heat sink.

### DETAILED DESCRIPTION

Although clear and complete description of the technical solutions of the embodiments of the present invention will be given below by reference to the accompanying drawings, it is obvious that these embodiments are simply some instead of all embodiments of the invention. All other embodiments that can be conceived by those skilled in the art without putting in inventive efforts on the basis of the embodiments of the present invention will fall within the scope of the invention.

Heat pipe principle: when heating the evaporator of the heat pipe, the operating liquid (operating medium) within the wick is subjected to heat and evaporated, carrying away some heat known as vaporization latent heat (vaporization heat) of the operating medium; and vapor flows through the central capillary channel to the condensator of the heat pipe, and condenses into liquid and releases heat at the same time, the capillary force (surface tension) pulls the liquid back into the evaporator. As such, a closed cycle is formed such that a great deal of heat is transmitted from the heating section to the radiating section. Heat pipe principle can be summarized in the following expressions: liquid turns into gas by taking in heat, gas is transmitted under gas pressure and gas turns back into liquid by releasing heat.

In the following description and the technical practice in the field, high power LED illuminant typically refers to the LED illuminant in which the power of a single piece of LED chip is higher than 0.5 watt. However, the present invention is not so limited, the technical solution(s) of the invention is/are also applicable to other LED illuminants of any other powers without departing from the general principle of the invention, i.e., electric-insulation-operating-medium drawn by capillary force is used for directly cooling the LED chips.

### Embodiments

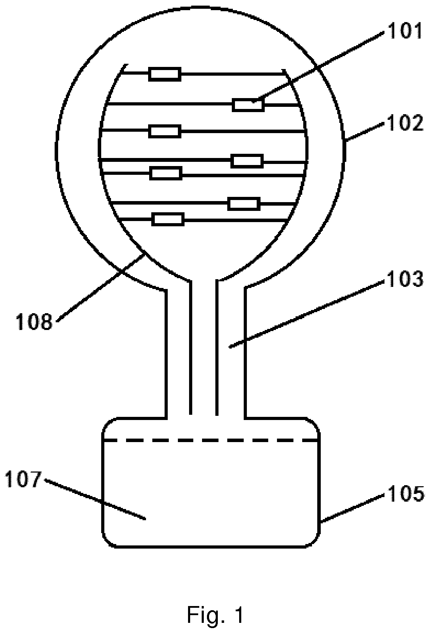

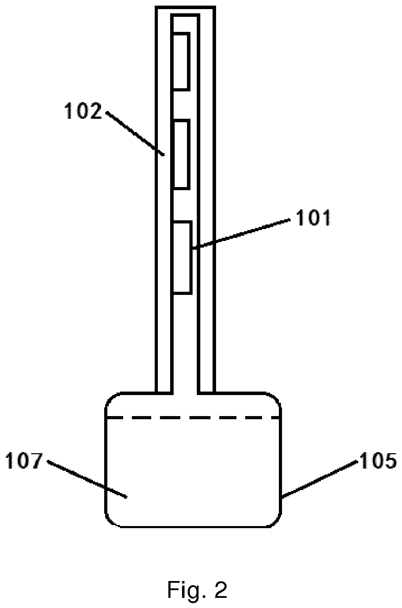

As shown in Figures 1, 2 and 3, a high power LED illuminant based on heat pipe principle comprises a light emitting section 102, a connecting section 103, a liquid storing section 105 in which some liquid electric-insulation-operating-medium 107 is stored and a heat sink 106, the structure is used for cooling the LED chips directly. The light emitting section 102, the connecting section 103 and the liquid storing section 105 are interconnected. The light emitting section 102 is provided with a first chamber within which several LED chips 101 are positioned. The dimension of the inner clearance of the first chamber ranges from 0.01mm to 2mm, that is, the distance from the left wall to the right wall of the inner chamber of the light emitting section 102 shown in figure 2 ranges from 0.01mm to 2mm. The light emitting section 102 draws liquid electric-insulation-operating-medium 107 by means of capillary force from the liquid storing section 105 and the liquid electric-insulation-operating-medium is turned into gas by taking in heat. The liquid storing section 105 is provided with a second chamber within which liquid electric-insulation-operating-medium 107 is stored. Heat sink 106 is used for lowering temperature of the gas electric-insulation-operating-medium to change it into liquid.

The LED chips of the high power LED illuminant are cooled by means of capillary principle of the heat pipe. The dimension of the inner clearance of the first chamber of the light emitting section 102 ranges from 0.01mm to 2mm to form capillary structure. Capillary channels are formed within the first chamber and the connecting section based on the principle of the heat pipe. The liquid electric-insulation-operating-medium is drawn into the first chamber from the liquid storing section and accumulates around the LED chips to cool the LED chips directly. When the LED chips generate heat during operation, the liquid electric-insulation-operating-medium takes in heat and then directly changes into gas, that is to say, heat will be taken in during the process of transition into gas. The electric-insulation-operating-medium flows through capillary channels of the connecting section 103 into the liquid storing section 105 connected with the heat sink 106. The electric-insulation-operating-medium gives out heat through the heat sink 106 and lowers its temperature to change into liquid. By means of such a cycle, the heat generated by LED chips is transferred away from the chips by the electric-insulation-operating-medium by means of its vaporization and liquefaction, thus keeping the temperature of the LED chips within the vaporization temperature of the electric-insulation-operating-medium. Accordingly, the lifespan of the LED chips is extended consequently and the luminous efficiency is enhanced as well.

It is to be noted that although the above described light emitting section 102 forms the capillary structure and realizes capillary effect through the first chamber with specific dimension, as would be appreciated by those skilled in the art, the present invention is obviously not limited to this specific capillary structure. Other equal modifications of the technical solutions of the invention can be made by those skilled in the art without departing from the general principle of the present invention, namely, drawing the electric-insulation-operating-medium to directly cool down the LED chips by means of capillary principle. Specifically, on one hand, the dimension of the inner clearance of the first chamber can be any appropriate dimension outside of the range from 0.01 mm to 2mm as long as capillary structure can be created; and on the other hand, the invention is not limited to the capillary structure formed with inner chamber, the light emitting section 102 may also be of solid structure embedded with LED chips as long as liquid electric-insulation-operating-medium can be drawn from liquid storing section 105 to surround the LED chips. For instance, the material surrounding the LED chips in the light emitting section 102 can be microporous material, such as microporous material created by means of heavy ion etching. Alternately, in the event that the LED chips are provided within the first chamber, the first chamber can be filled with micro-bead glass to increase capillary force to the greatest extent.

Preferably, as shown in figure 2, the first chamber is formed by holding two pieces of transparent material together and sealing their edges. In addition, as long as the edges of the first chamber are made gas-tight and liquid-tight, the sealing of the edges can be achieved by sealant or glass cement, or by using other sealing processes and materials or mechanical sealing structures. The liquid storing section 105 and the heat sink 106 can be an integral metal sealing structure.

Additionally, instead of using two pieces of transparent material, the first chamber can also be formed by holding metal based circuit board(s) and transparent material(s) together and sealing their edges. Particularly, based on existing conventional LED illuminant structures, the technical solutions of the present embodiment may also employ capillary structure which is created by holding metal based circuit board(s) such as aluminum based circuit board(s) and piece(s) of transparent material together.

Said transparent material can be transparent glass, transparent ceramics, transparent fluorescent ceramics, fluorescent glass, fluorescent film glass, lattice fluorescent film glass, fluorescent polymer film doped with fluorescent powder or other transparent materials, wherein the fluorescent film glass and the lattice fluorescent film glass can be produced by the preparation method disclosed in patent ZL 201210228419.3.

Preferably, the first chamber is also provided with a circuit 108 within it, on which the LED chips are located and connected. Specifically, the circuit 108 may be either printed on the inner wall of the first chamber or hang in the first chamber and the circuit 108 is led out of the first chamber, the connecting section 103 or the second chamber so as to connect with external power supply devices. Therefore, the LED chips and the circuit 108 are within the first chamber. The electric-insulation-operating-medium goes into the first chamber under the capillary force, immerses the LED chips and can cool down the LED chips directly.

Preferably, the connecting section 103 of capillary structure is located between the light emitting section 102 and the liquid storing section 105 and connects them with each other. The electric-insulation-operating-medium within the liquid storing section 105 flows into the light emitting section 102 through connecting section 103. After being heated and turning into gas, the electric-insulation-operating-medium returns to the liquid storing section 105 through the connecting section 103.

Preferably, the electric-insulation-operating-medium is simethicone. Several factors should be taken in to account when selecting the operating medium, including non-conducting, low boiling point, photo permeability, heat transfer coefficient, fluidity and non-affinity-effect with glass and so on. Preferably, silicone oil of low viscosity, in particular simethicone is suitable as the electric-insulation-operating-medium of present invention. Certainly, ethanol or diethyl ether etc. can also be used.

Moreover, the loading amount of the electric-insulation-operating-medium has large influence on heat transfer capability. If loaded with too much electric-insulation-operating-medium, excess electric-insulation-operating-medium will accumulate in the liquid storing section to increase thermal resistance of the liquid storing section, so as to raise the temperature of the LED illuminant. If loaded with too little electric-insulation-operating-medium, the clearance of the light emitting section cannot be fully filled with the electric-insulation-operating-medium, which gives rise to problem of partial drying of the light emitting section, thus impairing the heat transfer capability. If simethicone is used as the operating medium, the temperature of the LED chips in the high power LED illuminant can be maintained below 100°C for a very long time, because the boiling point of simethicone is about 100°C.

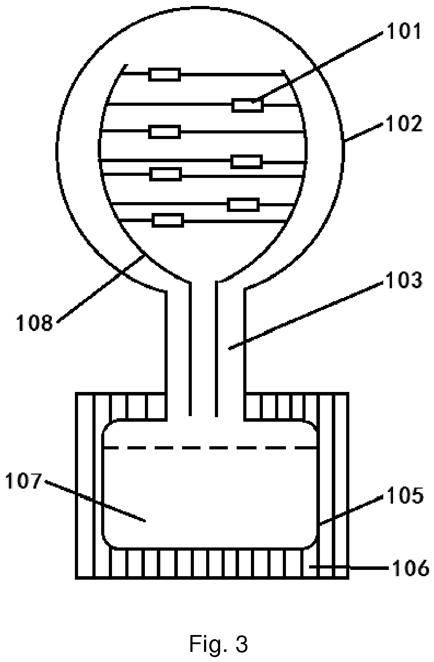

To further improve the effect of heat dissipation and avoid overheat of the light emitting section 102, as shown in Figure 3, the high power LED illuminant may also be provided with heat sink 106 connected with the liquid storing section 105. For example, the heat sink 106 may be an aluminum based heating panel.

The high power LED illuminant in the present embodiment is intended to fall within the scope of the invention as long as the electric-insulation-operating-medium is drawn into the light emitting section 102 and transferred between the light emitting section 102 and the liquid storing section 105 and the heat pipe with cycle of heat absorption and heat dissipation is formed to directly cool the LED chips.

Although there have been described several preferred embodiments, they are not intended to limit the present invention in any way. In light of the above disclosed technical substance, changes and modifications can be devised to form equivalent embodiments by those skilled in the art without departing from the technical solution of the invention. Any simple changes, equivalent variations and modifications to the above described embodiments are intended to fall within the scope of the technical solutions of the present invention.

## Claims

1. A high power LED illuminant based on heat pipe principle, **characterized by** comprising a light emitting section in which LED chips are provided and a liquid storing section with liquid electric-insulation-operating-medium stored therein, wherein the electric-insulation-operating-medium is used to directly cool down the LED chips,
wherein the light emitting section has capillary structure used to draw in the liquid electric-insulation-operating-medium by means of capillary force and to turn the electric-insulation-operating-medium into gas by taking in heat, wherein the liquid storing section is provided with a second chamber connected with the capillary structure and the liquid electric-insulation-operating-medium is stored within the second chamber.

2. The high power LED illuminant based on heat pipe principle as set forth in claim 1, **characterized in that** a first chamber which forms the capillary structure is provided within the light emitting section, wherein the LED chips are located within the first chamber.

3. The high power LED illuminant based on heat pipe principle as set forth in claim 2, **characterized in that** the first chamber has clearance ranging from 0.01mm to 2mm.

4. The high power LED illuminant based on heat pipe principle as set forth in claim 3, **characterized in that** the high power LED illuminant further includes a heat sink connected with the liquid storing section, wherein the heat sink is used for lowering the temperature of the gas electric-insulation-operating-medium to turn it into liquid electric-insulation-operating-medium.

5. The high power LED illuminant based on heat pipe principle as set forth in claim 3, **characterized in that** the first chamber is formed by holding two pieces of transparent material together and sealing their edges.

6. The high power LED illuminant based on heat pipe principle as set forth in claim 3, **characterized in that** the first chamber is formed by holding metal based circuit board(s) and transparent material(s) together and sealing their edges.

7. The high power LED illuminant based on heat pipe principle as set forth in claim 5, **characterized in that** the transparent material is transparent glass, transparent ceramics, transparent fluorescent ceramics, fluorescent glass, fluorescent film glass, lattice fluorescent film glass or other transparent materials.

8. The high power LED illuminant based on heat pipe principle as set forth in claim 2, **characterized in that** a circuit and the LED chips are located within the first chamber, and the LED chips are fixed on and electrically connected to the circuit.

9. The high power LED illuminant based on heat pipe principle as set forth in claim 1, **characterized in that** a connecting section with capillary structure is provided between the light emitting section and the light storing section and connects them with each other.

10. The high power LED illuminant based on heat pipe principle as set forth in claim 4, **characterized in that** the liquid storing section and the heat sink is an integral metal sealing structure or separate structures.

11. The high power LED illuminant based on heat pipe principle as set forth in claim 6, **characterized in that** the transparent material is transparent glass, transparent ceramics, transparent fluorescent ceramics, fluorescent glass, fluorescent film glass, lattice fluorescent film glass or other transparent materials.

12. The high power LED illuminant based on heat pipe principle as set forth in claim 3, **characterized in that** a circuit and the LED chips are located within the first chamber, and the LED chips are fixed on and electrically connected to the circuit.

13. The high power LED illuminant based on heat pipe principle as set forth in claim 4, **characterized in that** a circuit and the LED chips are located within the first chamber, and the LED chips are fixed on and electrically connected to the circuit.

14. The high power LED illuminant based on heat pipe principle as set forth in claim 5, **characterized in that** a circuit and the LED chips are located within the first chamber, and the LED chips are fixed on and electrically connected to the circuit.

15. The high power LED illuminant based on heat pipe principle as set forth in claim 6, **characterized in that** a circuit and the LED chips are located within the first chamber, and the LED chips are fixed on and electrically connected to the circuit.
